# EUROPEAN PATENT SPECIFICATION

(11) **EP 3 218 729 B1**
(45) Date of publication and mention of the grant of the patent: **30.10.2019**
(21) Application number: 15859469.7
(22) Date of filing: 09.11.2015
(51) Int. Cl.: G01R 31/26, H01L 21/301, H01L 21/78, G01R 1/067, G01R 31/319, G01R 31/28, H01L 25/00

(54) **ASSEMBLING DEVICES FOR PROBE CARD TESTING**
MONTAGEVORRICHTUNGEN ZUR NADELKARTENPRÜFUNG
DISPOSITIFS D'ASSEMBLAGE POUR ESSAI DE CARTE SONDE

(30) Priority: 10.11.2014 US 201414536928
(43) Date of publication of application: 20.09.2017
(73) Proprietor: Teradyne, Inc., North Reading, MA 01864 (US)
(72) Inventor: SINSHEIMER, Roger Allen, Camarillo, California 93010 (US)
(74) Representative: Conroy, John
(86) International application number: PCT/US2015/059713
(87) International publication number: WO 2016/077217

(56) References cited:
- WO-A2-2014/123697
- WO-A2-2014/123697
- US-A- 6 002 266
- US-A1- 2002 064 893
- US-A1- 2003 064 547
- US-A1- 2007 063 721
- US-A1- 2007 063 721
- US-A1- 2008 283 190
- US-A1- 2008 283 190
- US-A1- 2009 128 162
- US-A1- 2011 294 262
- US-A1- 2013 217 208
- US-A1- 2013 309 792
- US-A1- 2013 309 792

## Description

### TECHNICAL FIELD

This specification relates generally to assembling devices for probe card testing.

### BACKGROUND

Automatic Test Equipment (ATE) refers to an automated, usually computer-driven, system for testing devices, such as semiconductors, electronic circuits, and printed circuit board assemblies. A device tested by ATE is generally referred to as a device under test (DUT). ATE typically includes a computer system and a test instrument or a single device having corresponding functionality. Some types of ATE are designed to perform wafer-level testing of devices.

Wafer-level testing includes, among other things, testing devices (e.g., dice) on a wafer. Typically, dice are tested before the wafer is cut; the wafer into individual devices; and those devices are subjected to one or more manufacturing processes. The manufacturing processes can make the devices thinner and thus more fragile, making it difficult to test the devices individually without breaking them. Accordingly, the individual devices are often not tested after being cut from the wafer.

US 2007/0063721 describes a carrier that can hold a plurality of singulated dice while the dice are tested. The dice can be arranged on the carrier in a pattern that facilities testing the dice. The carrier can be configured to allow interchangeable interfaces to different testers to be attached to and detached from the carrier.

US 6,002,266 describes a singulated die test socket that is created from similar silicon material as the die being tested thereby producing a match of thermal coefficients of expansion between the socket and the die.

US 2002/0064893 describes an inspection of LSI chips in which a predetermined number N of chips are rearranged and integrated by using a jig for integration which is formed of a material whose coefficient of thermal expansion approximates that of the chips and in which is formed an accommodating portion for rearranging the predetermined number N of chips.

US 2003/0064547 describes a multi-chip module wherein a plurality of integrated circuit dice with at least one row of generally central bond pads is bonded in a staggered flip-chip style to opposite sides of a metallized substrate.

### SUMMARY

The invention is defined in the claims.

An example process places dice that have been cut from a first semiconductor wafer on a second wafer. The example process includes arranging the dice in a pattern on the second wafer, where the second wafer has a coefficient of thermal expansion that has substantially a same coefficient of thermal expansion as the dice. In some examples, the method includes using a probe card that is matched to a pattern of dice in connection with the second wafer. The example process may include one or more of the following features, either alone or in combination.

The arranging process may include applying an adhesive to the structure; and placing the dice on the adhesive in the pattern. The adhesive may decrease in adhesiveness in response to heat and/or in response to ultraviolet light.

The material of which the second wafer is formed may have a coefficient of thermal expansion that matches a coefficient of thermal expansion of the dice or that is within a predefined range around the coefficient of thermal expansion of the dice.

The material of which the second wafer is formed may include UV-transparent glass having a coefficient of thermal expansion that substantially matches a coefficient of thermal expansion of the dice. The second wafer may be made of of UV-transparent glass on which an adhesive is disposed, and the adhesive may decrease in adhesiveness in response to ultraviolet light. The second wafer may include silicon on which an adhesive is disposed, and the adhesive may decrease in adhesiveness in response to elevated temperature

The dice have a same pattern on the first wafer and on the second wafer.

The dice may have been selected or sorted for one or more performance characteristics before they are placed on the second wafer.

In some implementations, the first wafer and/or the second wafer has a shape that is other than round (e.g., square, rectangular, oval, or any other appropriate shape).

Example automatic test equipment (ATE) may include: a probe card configured to contact, for testing, dice that have been cut from a first semiconductor wafer, where the dice are on a second wafer; and a processing device to execute instructions to control testing performed by the probe card. The second wafer may have a coefficient of thermal expansion that has substantially a same coefficient of thermal expansion as the dice. The example ATE may include one or more of the following features, either alone or in combination.

The example ATE may include an adhesive between the second wafer and the dice, the adhesive holding the dice on the second wafer. The adhesive may have a composition that causes the adhesive to decrease in adhesiveness in response to heat and/or in response to ultraviolet light.

A material of which the second wafer is formed may include silicon having a coefficient of thermal expansion that matches a coefficient of thermal expansion of the dice or that is within a predefined range around the coefficient of thermal expansion of dice. The second wafer may include glass on which an adhesive is disposed, and the adhesive may have a composition that causes the adhesive to decrease in adhesiveness in response to ultraviolet light.

The dice are arranged in the same pattern on the first semiconductor wafer as the dice are arranged on the second wafer.

In some implementations, the first semiconductor wafer and/or the second wafer has a shape that is other than round (e.g., square, rectangular, oval, or any other appropriate shape).

Any two or more of the features described in this specification, including in this summary section, can be combined to form implementations not specifically described herein.

The test systems and techniques described herein, or portions thereof, can be implemented as/controlled by a computer program product that includes instructions that are stored on one or more non-transitory machine-readable storage media, and that are executable on one or more processing devices to control (e.g., coordinate) the operations described herein. The test systems and techniques described herein, or portions thereof, can be implemented as an apparatus, method, or electronic system that can include one or more processing devices and memory to store executable instructions to implement various operations.

The details of one or more implementations are set forth in the accompanying drawings and the description below. Other features and advantages will be apparent from the description and drawings, and from the claims.

### DESCRIPTION OF THE DRAWINGS

Fig. 1 is a perspective view of an example reconstituted wafer on an example support structure.
Fig. 2 is a conceptual block diagram of example testing performed on a reconstituted wafer on a support structure.
Fig. 3 is a flowchart showing an example testing process.
Figs. 4 and 5 are block diagrams showing example automatic test equipment (ATE) that may be used to perform the example testing processes described herein.

Like reference numerals in different figures indicate like elements.

### DETAILED DESCRIPTION

Manufacturers may test devices at various stages of manufacturing. In an example manufacturing process, integrated circuits are fabricated in large quantities on a single silicon wafer. The wafer is cut into individual devices (e.g., integrated circuits) called dice (in this specification, "dice" is used as the plural of "die"). In some cases, each die is loaded into a frame, and bonding wires are attached to chip scale packages to connect the die the frame. The loaded frame is then encapsulated in plastic or another packaging material to produce a finished product. In some cases, dice are either built up into WLCSPs, or Wafer Level Chip Scale Packages, mounted to an organic substrate either by bonding the die onto the substrate and using bond wires or via a C4/flip chip process, or are built into a 2-1/2 or 3D package where they are mounted using copper columns to another die that's already mounted using C4 technology to either an organic or silicon interposer. Once the substrate and chip or stack is built up, they are encapsulated. WLCSPs are encapsulated during manufacture.

Manufacturers have an economic incentive to detect and discard faulty components as early as possible in the manufacturing process. Accordingly, many manufacturers test integrated circuits at the wafer level, before a wafer is cut into dice. Defective circuits are marked and generally discarded prior to packaging, thus saving the cost of packaging defective dice. As a final check, manufacturers may test each finished product before it is shipped.

To test quantities of components, manufacturers commonly use ATE (or "testers"). In response to instructions in a test program set (TPS), example ATE automatically generates input signals to be applied to a device under test (DUT), and monitors output signals. The ATE compares the output signals with expected responses to determine whether the DUT is defective. ATE typically includes a computer system and a test instrument or a single device having corresponding functionalities. In some cases, the test instrument provides power to a DUT.

In some implementations, the ATE includes a probe or probe card (referred to simply as a "probe"). During wafer testing, the probe contacts one or more dice, which are part of the wafer, to send signals to, and receive signals from, the dice in order to test the dice. When a die passes testing, it is referred to as a "Known Good Die" (KGD). Thereafter, in some cases, various manufacturing processes may be performed on wafers that have been tested. In some cases, prior to forming a stack or other component structure, as many as twenty, thirty, or more processes may be performed on a wafer following test. Such processes may include, but are not limited to, chemical mechanical polishing (CMP), grinding, laser drilling, etching, and so forth. These processes can reduce the structural integrity of the wafer and/or the thickness of the wafer, in some cases down to, e.g., 100 µM, 80 µM, or less. Consequently, the wafer can become fragile (or more fragile), in many cases too fragile for subsequent conventional probe-based testing. That is, even though the dice are still in wafer form, performing testing using a probe may cause the wafer to break. Accordingly, further testing is not performed at this stage. Another issue with thinned wafers is that they tend to curl-up, making them difficult to test, in some cases. Rather, it should be assumed that KGD become "Probably Good Die" (PGD) as a result of the additional post-test processing.

In some examples, components made of PGD are stacked, with electrical connectivity between adjacent die being achieved vertically. For example, electrical vias may pass vertically through various dice to create electrical connections among the dice and an underlying circuit board or other structure. In some cases, stacks can have three-dimensional (3D) or two-and-a-half-dimensional (2.5D) configurations. In some cases, configurations such as this can result in a greater data transfer rate among components, and can result in more efficient operation, thereby reducing power consumption and allowing for extended battery life relative to other configurations. An issue with stacked configurations is that, if one component in the stack is defective, then the entire stack is defective. Without testing PGD-based components following post-test processing, the likelihood of defective components, and thus defective stacks, is increased. The issue of possibly defective PGD is, however, not limited to stacked component configurations. That is, following post-test processing, the likelihood of a die being defective will be generally greater than prior to post-test processing.

Accordingly, described herein are example processes for testing dice following post-test processing. In the examples described herein, the testing may be performed even in cases where dice have become more fragile due to the post-test processing. For example, in some implementations, following testing and post-test processing, the wafer is cut into individual die. These cut dice may be used to reconstitute a wafer on an appropriate support structure (e.g., a glass wafer, a silicon wafer, or a wafer made of other material(s)). In this regard, a wafer is "reconstituted" in the sense that dice are arranged on the structure in a wafer-like pattern; it does not mean that the original wafer from which the dice were cut, with the original silicon, is re-formed. The dice (which are PGD, at this point) that are part of the reconstituted wafer may be tested en masse on the support structure, in some cases using the same probe card that was used to test the original wafer (although that is not a requirement of the processes described herein, as explained below). By virtue of this additional round of testing, PGD can again be classified by the tester as KGD, at least for PGD that pass the appropriate tests. As a result, there is less likelihood of defects in resulting structures, such as the stacked structures noted above, that can be attributed to post-test processing of dice.

Described herein are example methods of testing devices (e.g., PGD) that have been cut from a semiconductor wafer and that have been subjected to one or more manufacturing processes that affect the fragility of those devices. An example method includes arranging the devices in a pattern on a structure having a coefficient of thermal expansion (CTE) that has substantially a same CTE as the devices and as a material from which the original semiconductor wafer was formed; and testing the devices on the structure using a probe tester that is usable with the pattern. In this regard, as noted, in this example implementation, the PGD are arranged on (and attached to) a structure having a CTE that has substantially a same CTE as the devices and as a material of which the original semiconductor wafer was formed. As a result, when the structure and PGD heat during testing, as typically occurs, motion of the assembled structure will match (or match to within an appropriate range/tolerance) the expansion of the PGD themselves and the expansion that would have occurred during testing of the original semiconductor wafer from which the PGD were cut. In this regard, while it is true (as stated above) that heating is a possible consequence of the testing process, it is more true that the application of heat (or cold) is often used as a stressor on the dice to check for possible failure. Other stressors include, but are not limited to, over- or under-voltage. Today, chips are tested at temperatures as high as 200° C and as low as -55° C. These temperatures are achieved by either heating or cooling the chuck the wafer is sitting on during test

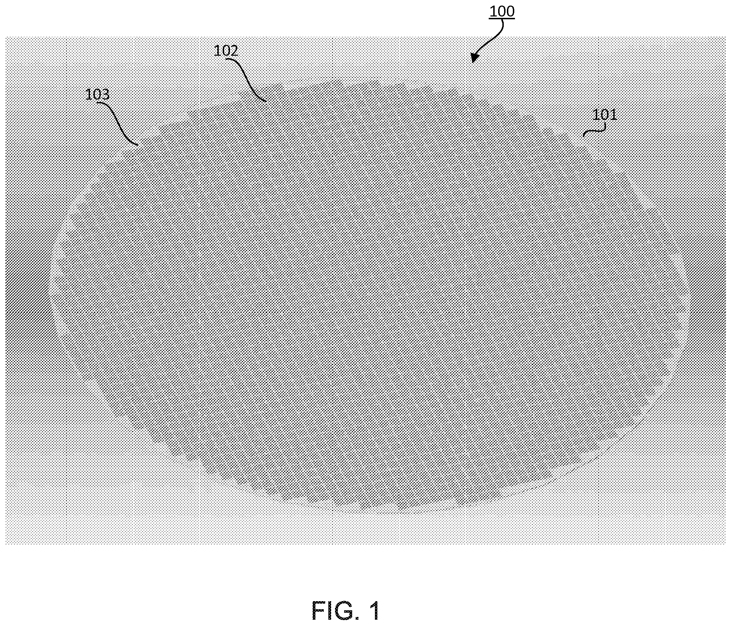

Fig. 1 shows an example implementation of a reconstituted wafer 100. In this example, the wafer is reconstituted on a glass structure 101, such as Pyrex® or any other appropriate borosilicate glass; however, any appropriate material may be used for structure 101. In this example, Pyrex® is used because it has a CTE that is about the same as silicon (e.g., within an appropriate range/tolerance of the CTE of silicon), thereby making Pyrex® an appropriate structure for use with silicon-based dice cut from silicon wafers. Advantageously, glass wafers are also flat, which facilitates wafer reconstitution. However, different materials (other than glass or Pyrex®) may be more appropriate for some silicon wafers and for wafers that are based on materials other than silicon.

In some implementations, structure 101 may be a second wafer made of silicon, and not glass. In other implementations, different materials may be used.

In this example, dice 102 are held onto structure 101 using an adhesive 103. Examples of adhesives that may be used are described below. In this example, the individual die are arranged on the structure to approximate the dice pattern on, and shape of, the original wafer from which the dice were cut. Arranging the dice to approximate the dice pattern on, and shape of, the original wafer can be advantageous, since it enables the probe that tested the original wafer to be used also to test the reconstituted wafer. However, it is not a requirement that the individual die be arranged on the structure to approximate the dice pattern on, and shape of, the original wafer from which the dice were cut. Rather, the individual die may be arranged on the structure in any appropriate pattern, and to form any appropriate shape, to match corresponding test connections on a probe card. In some implementations, it may be advantageous to arrange the dice at a pitch that exceeds the pitch at which they were arranged on the original wafer. That is, the dice may be farther apart from each other in the reconstituted wafer than on the original wafer. A widened pitch may facilitate testing, since it can allow for larger-pitched probes to be used, which can be easier to operate than their smaller-pitched counterparts. On the other hand, smaller pitches may provide greater testing throughput. If it is deemed advantageous, the die can be placed in a rectangular or other shape pattern, rather than in a pattern to match the original round wafer.

In some implementations, the dice may be selected or sorted for one or more performance characteristics before they are placed on the structure for testing. For example, the dice may be selected based on test to be performed thereon or based on their compatibility with other dice on the reconstituted wafer.

In an example implementation, the adhesive used to hold the dice on structure 101 may be a type of tape or any other appropriate adhesive material. In some implementations, an adhesive is used that decreases in adhesiveness (stickiness) in response to heat. For example, following testing of PGD on the reconstituted wafer, heat may be applied thereto, causing the adhesive to decrease in adhesiveness, thereby enabling removal of the tested PGD (now, again, KGD) without damage (or at least with a lower risk of damage than peeling the KGD from a still-sticky adhesive). In some implementations, an adhesive is used that decreases in adhesiveness in response to ultraviolet (or other wavelength) of light. For example, following testing of PGD on the reconstituted wafer, UV light may be applied thereto, causing the adhesive to decrease in adhesiveness, thereby enabling removal of the tested PGD (now, again, KGD) without damage (or at least with a lower risk of damage than peeling the KGD from a still-sticky adhesive). In some implementations, an adhesive is used that decreases in adhesiveness in response to a medium or agent other than heat or light.

In some implementations, some adhesives may be more appropriate for use than other adhesives. For example, in the case of a structure material that is opaque, use of a heat-releasing adhesive may be advantageous relative to a UV-releasing adhesive. This is because, in the case of an opaque structure, the UV (which may be applied from underneath the structure) may not be able to reach the adhesive, thereby inhibiting release of dice from the structure following testing. By contrast, in the case of a silicon-based structure, then a heat-releasing adhesive may be more appropriate.

In the example implementations described below, reconstituted wafers are used as part of testing processes. However, reconstituted wafers, such as those described herein, are not limited to use in a testing context, and may be used with any appropriate probe card for any appropriate purpose.

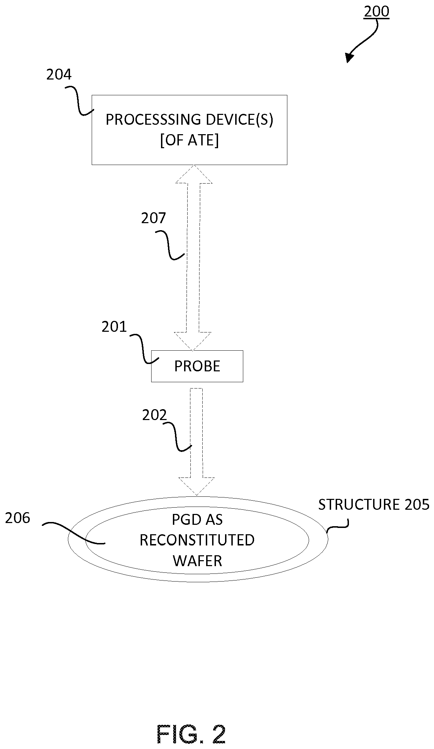

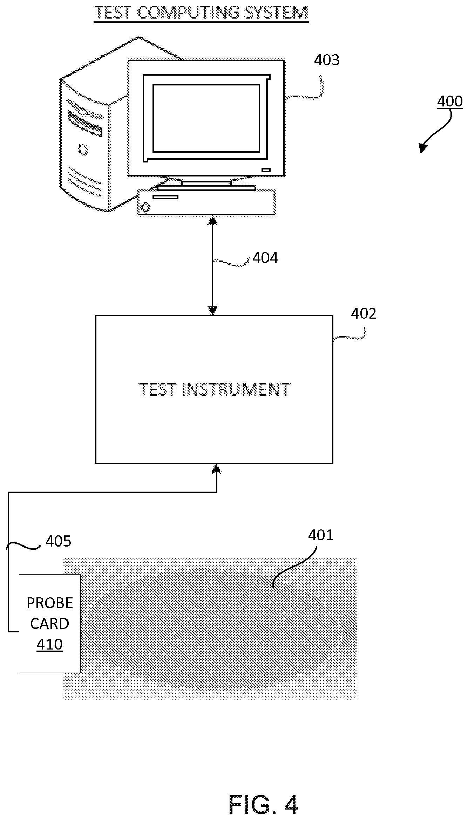

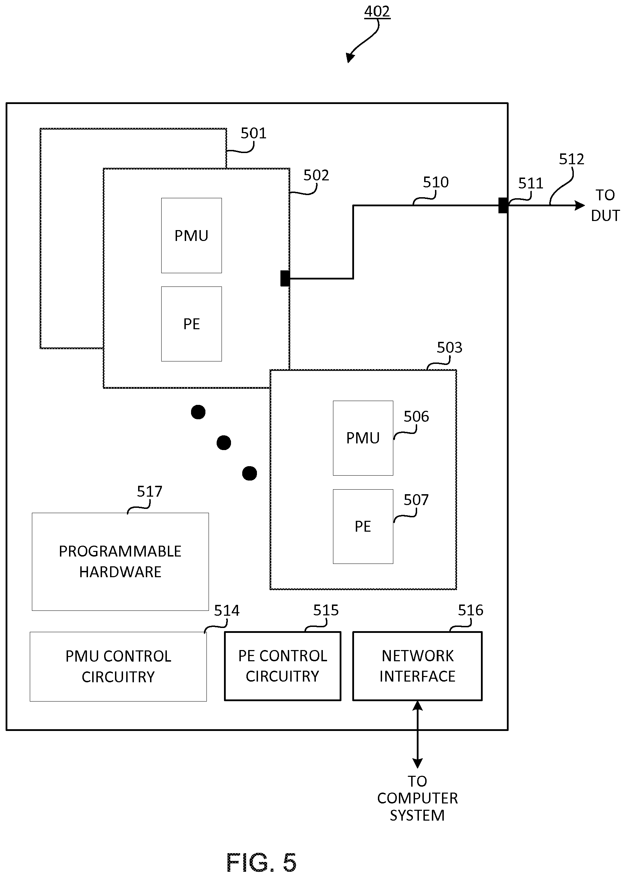

Referring to Fig. 2, automatic test equipment (ATE) 200 for testing dice on wafers, including reconstituted wafers, is shown in block diagram form. A more detailed description of the ATE that may be used in the testing processes described herein is provided with respect to Figs. 4 and 5. As shown in Fig. 2, ATE 200 includes a probe card (or simply, probe) 201 configured to contact dice for testing as indicated graphically by arrow 202; one or more processing devices 204 (e.g., one or more computers) to execute instructions to control testing performed via probe 201 as indicated graphically by arrow 207; and a structure 205, on which PGD 206 (in this example) are arranged for contact with the probe. As explained herein, the structure includes an adhesive to which the PGD are attached.

As noted above, in this example implementation, structure 205 has a CTE that is substantially the same as the CTE of the original wafer from which the PGD were cut. In some example implementations, however, structure 205 may have a CTE that is known, but that is not substantially the same as the CTE of the material of the original wafer from which the PGD were cut.

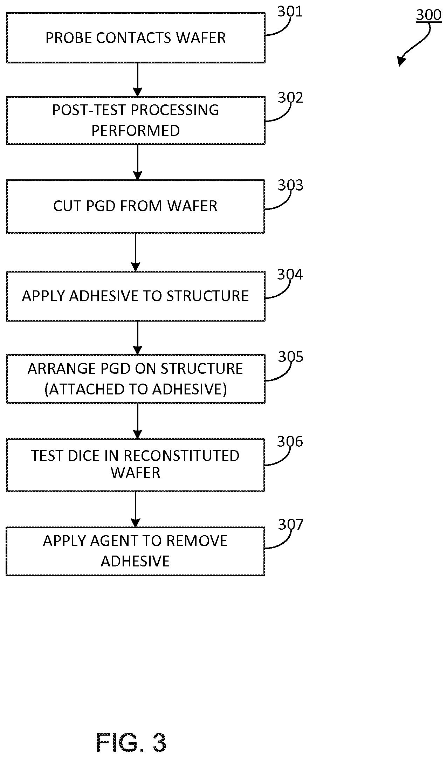

Referring to Fig. 3, a testing and manufacturing process 300 performed, in part, by ATE 200 may include the following operations. According to process 300, probe 201 contacts (301) an original wafer (not shown in the figures) to test dice contained thereon. The dice that pass the test are characterized by the ATE as KGD. Thereafter, post-test processing (302), such as CMP, grinding, or the like, are performed on the wafer, causing the wafer to become more fragile. As a result, the KGD are re-characterized as PGD by the ATE. Individual PGD are cut (303) from the wafer for use, e.g., in forming an electrical device, which may include the stacked component configuration described above or any other appropriate configuration. Prior to forming the electrical device, however, the PGD may be tested in the manner described herein. An example testing process includes reconstituting a wafer on structure 205, and performing testing on the reconstituted wafer using probe 201. As explained above, a wafer is "reconstituted" in the sense that dice are arranged on the structure in a wafer-like pattern; it does not mean that the original wafer, with the original silicon is actually physically re-formed.

According to process 300, an adhesive (e.g., a light-releasing adhesive, a heat-releasing adhesive, or any other appropriate adhesive) is applied (304) to structure 205. In some implementations, this operation may be performed at another time, so long as the adhesive remains sticky enough to attach the PGD to structure 205. The adhesive may be tape, as noted above, or any other appropriate material. Thereafter, the PGD are arranged (305) in an appropriate pattern (e.g., a pattern that corresponds to a test connection pattern of probe 201) on the adhesive on structure 205. The PGD may be arranged automatically (e.g., using one or more robotic mechanisms), manually, or a combination thereof. The PGD stick/attach to the adhesive and, in this example, are in a wafer-like pattern, thereby forming a reconstituted wafer. Probe 201 tests (306) the PGD in the same manner as it originally tested the original dice on the original wafer. In some examples, the same tests may be performed and, in other examples, different tests may be performed.

The PGD that pass the tests may again be characterized by the test system as KGD. Following testing, heat, appropriate (e.g., UV) light, or any other appropriate adhesive-reducing agent is applied (307) to the adhesive to cause the adhesive decrease in adhesiveness and, thereby, release the KGD from structure 205. The KGD then may be used for any appropriate purpose.

The example testing techniques described herein are not limited to use during manufacture. Rather, they may be applied to test dice at any appropriate time. For example, the testing techniques may be used to test reels of dice, which may be purchased from an unfamiliar or unreliable source. The testing techniques may be used to identify malicious dice (e.g., those purposely corrupted), and so forth.

As noted above, the testing techniques described herein may be implemented, at least in part, on ATE. In an example operation, ATE (also referred to as "testers" or "test systems") operates in accordance with instructions in a test program set (TPS) to automatically generate input signals to be applied to a DUT, such as the dice or PGD described above, and to monitor output signals from the DUT. The ATE compares the output signals with expected responses to determine whether the DUT is defective. ATE typically includes a computer system and a test instrument or a single device having corresponding functionalities.

Referring to Fig. 4, ATE 400 for testing a device-under-test (DUT) 401, such dice on a wafer or reconstituted wafer, includes a test instrument 402. To control test instrument 402, system 400 includes a test computer system 403 that interfaces with test instrument 402 over a hardwire connection 404. Typically, computer system 403 sends commands to test instrument 402 to initiate execution of routines and functions for testing DUT 401 (e.g., a die on a wafer or part of a reconstituted wafer). Such executing test routines may initiate the generation and transmission of test signals to the DUT 401 and collect responses from the DUT. Various types of DUTs may be tested by system 400. For example, DUTs may be semiconductor devices including, but not limited to, an integrated circuit (IC) chip (e.g., memory chip, microprocessor, analog-to-digital converter, digital-to-analog converter, etc.).

To provide test signals and collect responses from the DUT, a probe card 410 of the test instrument 402 is connected to one or more connector contacts that provide an interface to contacts on DUT 401. A conductor 405 (e.g., cable) is connected to probe card 410 and is used to deliver test signals (e.g., parametric measurement unit ("PMU") test signals, contact electronics ("PE") test signals, etc.) to the internal circuitry of DUT 401. Conductor 405 also senses signals in response to the test signals provided by test instrument 402. For example, a voltage signal or a current signal may be sensed at a contact in response to a test signal and sent over conductor 405 to test instrument 402 for analysis. Such single port tests may also be performed on other contacts included in DUT 401. For example, test instrument 402 may provide test signals to contacts and collect associated signals reflected back over conductors (that deliver the provided signals). In some test scenarios, a digital signal may be sent over conductor 405 to a contact on DUT 401 for storing a digital value on DUT 401. Once stored, DUT 401 may be accessed to retrieve and send the stored digital value over conductor 405 to test instrument 402. The retrieved digital value may then be identified to determine if the proper value was stored on DUT 401.

Along with performing one-port measurements, a two-port test may also be performed by test instrument 402. For example, a test signal may be injected over conductor 405 into a DUT contact and a response signal may be collected from one or more other contacts of DUT 401. This response signal is provided to test instrument 402 to determine quantities, such as gain response, phase response, and other throughput measurement quantities.

Referring also to Fig. 5, to send and collect test signals from multiple contacts of a DUT (or multiple DUTs), semiconductor device test instrument 402 includes an interface card 501 that can communicate with DUT contacts. For example, interface card 501 may transmit test signals to DUT contacts (via the probe card) and collect corresponding responses. Each communication link to a contact is referred to as a channel and, by providing test signals to a large number of channels, testing time is reduced since multiple tests may be performed simultaneously. Along with having many channels on an interface card, by including multiple interface cards in test instrument 402, the overall number of channels increases, thereby further reducing testing time. In this example, two additional interface cards 502 and 503 are shown to demonstrate that multiple interface cards may populate test instrument 402.

Each interface card includes a dedicated integrated circuit (IC) chip (e.g., an application specific integrated circuit (ASIC)) for performing particular test functions. For example, interface card 503 includes one or more IC chips for performing parametric measurement unit (PMU) tests and contact electronics (PE) tests. To perform these functions, the one or more IC chips include a PMU stage 506 that includes circuitry for performing PMU tests and a PE stage 507 that includes circuitry for performing PE tests. Additionally, interface cards 501 and 502 each include one or more IC chips that include PMU and PE circuitry.

PMU testing involves providing a DC voltage or current signal to the DUT to determine such quantities as input and output impedance, current leakage, and other types of DC performance characterizations. PE testing involves sending AC test signals, or waveforms, to a DUT (e.g., DUT 401) and collecting responses to further characterize the performance of the DUT. For example, the PE stage may transmit (to the DUT) AC test signals that represent a vector of binary values for storage on the DUT. Once these binary values have been stored, the DUT may be accessed by test instrument 402 to determine if the correct binary values have been stored. Since digital signals typically include abrupt voltage transitions, the circuitry in PE stage may operate at a high speed relative to the circuitry in PMU stage.

To pass both DC and AC test signals from interface card 501 to DUT 401, a conducting trace 510 connects an interface board connector 511 that allows signals to be passed on and off the interface board. Interface board connector 511 is also connected to a conductor 512, which allows signals to be passed to and from test instrument 402. In this example, conductor 512 is connected to interface connector 511 for bi-directional signal passage between test instrument 402 and the DUT.

In this example, test instrument 402 includes PMU control circuitry 514 to, among other things, coordinate operations of the various PMU stages; PE control circuitry 515 to, among other things, coordinate operations of the various PE stages; and network interface 516 to communicate with the test computer system 403 over a network or hard-wired connection. Tester 401 also includes, in this example, programmable hardware 517, such as a field-programmable gate array ("FPGA") semiconductor device, that is capable of being programmed so to enable test instrument 402 to interact with DUT 401 to perform various test operations.

While this specification describes example implementations related to "testing" and a "test system," the processes and associated circuitry described herein may be used in any appropriate system, and are not limited to the test systems and manufacturing processes described herein.

Testing performed as described herein may be implemented using hardware or a combination of hardware and software. For example, a test system like the ones described herein may include various controllers and/or processing devices located at various points. A central computer may coordinate operation among the various controllers or processing devices. The central computer, controllers, and processing devices may execute various software routines to effect control and coordination of testing and calibration.

Testing can be controlled, at least in part, using one or more computer program products, e.g., one or more computer program tangibly embodied in one or more information carriers, such as one or more non-transitory machine-readable media, for execution by, or to control the operation of, one or more data processing apparatus, e.g., a programmable processor, a computer, multiple computers, and/or programmable logic components.

A computer program can be written in any form of programming language, including compiled or interpreted languages, and it can be deployed in any form, including as a stand-alone program or as a module, component, subroutine, or other unit suitable for use in a computing environment. A computer program can be deployed to be executed on one computer or on multiple computers at one site or distributed across multiple sites and interconnected by a network.

Actions associated with implementing all or part of the testing and calibration can be performed by one or more programmable processors executing one or more computer programs to perform the functions described herein. All or part of the testing and calibration can be implemented using special purpose logic circuitry, e.g., an FPGA (field programmable gate array) and/or an ASIC (application-specific integrated circuit).

Processors suitable for the execution of a computer program include, by way of example, both general and special purpose microprocessors, and any one or more processors of any kind of digital computer. Generally, a processor will receive instructions and data from a read-only storage area or a random access storage area or both. Elements of a computer (including a server) include one or more processors for executing instructions and one or more storage area devices for storing instructions and data. Generally, a computer will also include, or be operatively coupled to receive data from, or transfer data to, or both, one or more machine-readable storage media, such as mass PCBs for storing data, e.g., magnetic, magneto-optical disks, or optical disks. Machine-readable storage media suitable for embodying computer program instructions and data include all forms of non-volatile storage area, including by way of example, semiconductor storage area devices, e.g., EPROM, EEPROM, and flash storage area devices; magnetic disks, e.g., internal hard disks or removable disks; magneto-optical disks; and CD-ROM and DVD-ROM disks.

Any "electrical connection" as used herein may imply a direct physical connection or a connection that includes intervening components but that nevertheless allows electrical signals (including wireless signals) to flow between connected components. Any "connection" involving electrical circuitry mentioned herein, unless stated otherwise, is an electrical connection and not necessarily a direct physical connection regardless of whether the word "electrical" is used to modify "connection".

Elements of different implementations described herein may be combined to form other embodiments not specifically set forth above. Elements may be left out of the structures described herein without adversely affecting their operation. Furthermore, various separate elements may be combined into one or more individual elements to perform the functions described herein.

## Claims

1. A method of testing dice following post-test processing, the method comprising:
placing dice (102, 206) that have been cut from a first semiconductor wafer on a second wafer (101, 205), comprising arranging the dice in a pattern on the second wafer, the second wafer having a coefficient of thermal expansion that has substantially a same coefficient of thermal expansion as the dice such that thermal motion of the dice on the second wafer matches to within an appropriate tolerance thermal motion that would have occurred during testing of the first semiconductor wafer, wherein the dice are in a same pattern on the first wafer and on the second wafer.

2. The method of claim 1, wherein arranging comprises:
applying an adhesive (103) to the structure; and
placing the dice on the adhesive in the pattern, and optionally wherein the adhesive decreases in adhesiveness in response to application of heat or in response to application of ultraviolet light.

3. The method of claim 1, wherein the material of which the second wafer is formed comprises UV-transparent glass.

4. The method of claim 1, wherein the second wafer is comprised of a UV-transparent glass on which an adhesive (103) is disposed, and the adhesive decreases in adhesiveness in response to ultraviolet light.

5. The method of claim 1, wherein the second wafer is comprised of silicon on which an adhesive (103) is disposed and the adhesive decreases in adhesiveness in response to elevated temperature.

6. The method of claim 1, wherein the dice have been selected or sorted for one or more performance characteristics before they are placed on the second wafer.

7. The method of claim 1, wherein the first wafer or the second wafer has a shape that is other than round.

8. The method of claim 1, further comprising:
using a probe card (201, 410) that is matched to a pattern of dice in connection with the second wafer.

9. The method of any preceding claim, further comprising heating or cooling a chuck on which the second wafer is sitting on during the testing.

10. A method comprising:
wafer testing by contacting probe contacts of a probe card to dice that are part of a first wafer, to send signals to, and receive signals from, the dice;
performing a manufacturing process on the first wafer that has been tested; and
testing the dice following the manufacturing process using the method according to any one of claims 1 to 9 and the same probe card.

11. Automatic test equipment (200, 400) comprising:
a probe card (201, 410) configured to contact, for testing, dice (102, 206) ; and
a processing device (204, 514, 515) to execute instructions to control testing performed by the probe card; and
a second wafer (101, 205) having a coefficient of thermal expansion that has substantially a same coefficient of thermal expansion as dice thereon such that thermal motion of the dice on the second wafer matches to within an appropriate tolerance thermal motion that would have occurred during testing of a first semiconductor wafer from which the dice have been cut, wherein the dice are in a same pattern on the first semiconductor wafer as the dice are arranged on the second wafer.

12. The automatic test equipment of claim 10, further comprising an adhesive (103) between the second wafer and the dice, the adhesive holding the dice on the second wafer, and optionally wherein the adhesive has a composition that causes the adhesive to decrease in adhesiveness in response to heat or in response to ultraviolet light.

13. The automatic test equipment of claim 10, wherein a material of which the second wafer is formed comprises silicon.

14. The automatic test equipment of claim 10, wherein the second wafer comprises glass on which an adhesive (103) is disposed, and the adhesive has a composition that causes the adhesive to decrease in adhesiveness in response to ultraviolet light.

15. The automatic test equipment of claim 10, wherein the first semiconductor wafer or the second wafer has a shape that is other than round.

## Patentansprüche

1. Verfahren zum Prüfen von Chips im Anschluss an eine auf die Prüfung folgende Verarbeitung, wobei das Verfahren umfasst:
Platzieren von aus einem ersten Halbleiterwafer gesägten Chips (102, 206) auf einen zweiten Wafer (101, 205), umfassend ein Anordnen der Chips in einem Muster auf dem zweiten Wafer, wobei der zweite Wafer einen Wärmeausdehnungskoeffizienten aufweist, der einen im Wesentlichen gleichen Wärmeausdehnungskoeffizienten aufweist wie die Chips, so dass die Wärmebewegung der Chips auf dem zweiten Wafer innerhalb einer angemessenen Toleranz einer Wärmebewegung entspricht, die während des Prüfens des ersten Halbleiterwafers aufgetreten ist, wobei die Chips auf dem ersten Wafer und auf dem zweiten Wafer im gleichen Muster vorliegen.

2. Verfahren nach Anspruch 1, wobei das Anordnen umfasst:
Aufbringen eines Klebstoffes (103) auf die Struktur; und
Platzieren der Chips auf den Klebstoff im Muster, und wahlweise wobei das Haftvermögen des Klebstoffes als Reaktion auf ein Beaufschlagen mit Wärme oder als Reaktion auf ein Beaufschlagen mit ultraviolettem Licht abnimmt.

3. Verfahren nach Anspruch 1, wobei das Material, aus welchem der zweite Wafer ausgebildet ist, ein UV-transparentes Glas umfasst.

4. Verfahren nach Anspruch 1, wobei der zweite Wafer ein UV-transparentes Glas umfasst, auf welchem ein Klebstoff (103) angeordnet ist, und das Haftvermögen des Klebstoffes als Reaktion auf ultraviolettes Licht abnimmt.

5. Verfahren nach Anspruch 1, wobei der zweite Wafer ein Silizium umfasst, auf welchem ein Klebstoff (103) angeordnet ist, und das Haftvermögen des Klebstoffes als Reaktion auf eine erhöhte Temperatur abnimmt.

6. Verfahren nach Anspruch 1, wobei die Chips nach einem oder mehreren Leistungsmerkmalen ausgewählt oder sortiert worden sind, bevor sie auf den zweiten Wafer platziert werden.

7. Verfahren nach Anspruch 1, wobei der erste Wafer oder der zweite Wafer eine nichtrunde Form aufweist.

8. Verfahren nach Anspruch 1, das ferner umfasst:
Verwenden einer Nadelkarte (201, 410), die an ein Chipmuster im Zusammenhang mit dem zweiten Wafer angepasst ist.

9. Verfahren nach einem der vorhergehenden Ansprüche, das ferner ein Erwärmen oder Kühlen eines Vakuumtellers umfasst, auf welchem der zweite Wafer während des Prüfens liegt.

10. Verfahren, das umfasst:
Prüfen eines Wafers durch Kontaktieren von Chips, die Teil eines ersten Wafers sind, mit Prüfkontakten einer Nadelkarte, um Signale an die Chips zu senden und Signale aus den Chips zu empfangen;
Durchführen eines Herstellungsprozesses am geprüften ersten Wafer; und
Prüfen der Chips im Anschluss an den Herstellungsprozess unter Verwendung des Verfahrens nach einem der Ansprüche 1 bis 9 und derselben Nadelkarte.

11. Automatische Prüfeinrichtung (200, 400), die umfasst:
eine Nadelkarte (201, 410), die zum Kontaktieren, zum Prüfen, von Chips (102, 206) ausgelegt ist; und
eine Verarbeitungsvorrichtung (204, 514, 515) zum Ausführen von Instruktionen zum Steuern des von der Nadelkarte durchgeführten Prüfens; und
einen zweiten Wafer (101, 205), der einen Wärmeausdehnungskoeffizienten aufweist, der einen im Wesentlichen gleichen Wärmeausdehnungskoeffizienten aufweist wie auf diesem befindliche Chips, so dass die Wärmebewegung der Chips auf dem zweiten Wafer innerhalb einer angemessenen Toleranz einer Wärmebewegung entspricht, die während des Prüfens eines erstens Halbleiterwafers aufgetreten ist, aus welchem die Chips gesägt sind, wobei die Chips auf dem ersten Halbleiterwafer im gleichen Muster vorliegen, in dem die Chips auf dem zweiten Wafer angeordnet sind.

12. Automatische Prüfeinrichtung nach Anspruch 10, die ferner einen Klebstoff (103) zwischen dem zweiten Wafer und den Chips umfasst, wobei der Klebstoff die Chips auf dem zweiten Wafer hält, und wahlweise wobei der Klebstoff eine Zusammensetzung aufweist, die bewirkt, dass das Haftvermögen des Klebstoffes als Reaktion auf Wärme oder als Reaktion auf ultraviolettes Licht abnimmt.

13. Automatische Prüfeinrichtung nach Anspruch 10, wobei ein Material, aus welchem der zweite Wafer ausgebildet ist, Silizium umfasst.

14. Automatische Prüfeinrichtung nach Anspruch 10, wobei der zweite Wafer Glas umfasst, auf welchem ein Klebstoff (103) angeordnet ist, und der Klebstoff eine Zusammensetzung aufweist, die bewirkt, dass das Haftvermögen des Klebstoffes als Reaktion auf ultraviolettes Licht abnimmt.

15. Automatische Prüfeinrichtung nach Anspruch 10, wobei der erste Halbleiterwafer oder der zweite Wafer eine nichtrunde Form aufweist.

## Revendications

1. Procédé de test de puces après un traitement de contrôle ultérieur, le procédé comprenant :
le placement de puces (102, 206) découpées dans une première plaquette de semi-conducteur sur une deuxième plaquette (101, 205), comprenant l'agencement des puces selon un motif sur la deuxième plaquette, la deuxième plaquette présentant un coefficient de dilatation thermique présentant substantiellement le même coefficient de dilatation thermique que les puces de sorte que le mouvement thermique des puces sur la deuxième plaquette correspond avec une tolérance appropriée à un mouvement thermique qui serait survenu pendant le test de la première plaquette de semi-conducteur, les puces se trouvant dans le même motif sur la première plaquette et sur la deuxième plaquette.

2. Procédé selon la revendication 1, dans lequel l'agencement comprend :
l'application d'un adhésif (103) à la structure ; et
le placement des puces sur l'adhésif selon le motif, et en option, dans lequel l'adhésif perd en adhésivité en réponse à l'application de chaleur ou en réponse à l'application d'une lumière ultraviolette.

3. Procédé selon la revendication 1, dans lequel le matériau dont est formée la deuxième plaquette comprend du verre transparent aux UV.

4. Procédé selon la revendication 1, dans lequel la deuxième plaquette est composée de verre transparent aux UV sur lequel est disposé un adhésif (103), et l'adhésif perd en adhésivité en réponse à la lumière ultraviolette.

5. Procédé selon la revendication 1, dans lequel la deuxième plaquette est composée de silicium sur lequel est disposé un adhésif (103) et l'adhésif perd en adhésivité en réponse à une température élevée.

6. Procédé selon la revendication 1, dans lequel les puces ont été sélectionnées ou triées selon une ou plusieurs caractéristiques de performance avant d'être placées sur la deuxième plaquette.

7. Procédé selon la revendication 1, dans lequel la première plaquette ou la deuxième plaquette présente une autre forme que ronde.

8. Procédé selon la revendication 1, comprenant en outre :
l'utilisation d'une carte à sondes (201, 410) qui correspond à un motif de puces connectées à la deuxième plaquette.

9. Procédé selon l'une quelconque des revendications précédentes, comprenant en outre le chauffage ou le refroidissement d'un mandrin sur lequel est située la deuxième plaquette pendant le test.

10. Procédé, comprenant :
le fait de tester des plaquettes en mettant en contact des contacts de sonde d'une carte à sondes avec des puces qui font partie d'une première plaquette, pour envoyer des signaux aux puces et recevoir des signaux des puces ;
l'exécution d'un processus de fabrication sur la première plaquette qui a été testée ; et
tester les puces après le processus de fabrication en utilisant le procédé selon l'une quelconque des revendications 1 à 9 et la même carte à sondes.

11. Equipement de test automatique (200, 400), comprenant :
une carte à sondes (201, 410) configurée pour contacter des puces (102, 206) pour le test ; et
un dispositif de traitement (204, 514, 515) pour exécuter des instructions pour commander un test effectué par la carte à sondes ; et
une deuxième plaquette (101, 205) présentant un coefficient de dilatation thermique qui présente substantiellement le même coefficient de dilatation thermique que les puces sur celle-ci de sorte que le mouvement thermique des puces sur la deuxième plaquette correspond avec une tolérance appropriée au mouvement thermique qui serait survenu pendant le test d'une première plaquette de semi-conducteur dans laquelle les puces ont été découpées, les puces se trouvant dans le même motif sur la première plaquette de semi-conducteur lorsque les puces sont agencées sur la deuxième plaquette.

12. Equipement de test automatique selon la revendication 10, comprenant en outre un adhésif (103) entre la deuxième plaquette et les puces, l'adhésif maintenant les puces sur la deuxième plaquette, et en option, dans lequel l'adhésif présente une composition qui fait que l'adhésif perd en adhésivité en réponse à la chaleur ou en réponse à la lumière ultraviolette.

13. Equipement de test automatique selon la revendication 10, dans lequel un matériau dont est formée la deuxième plaquette comprend du silicium.

14. Equipement de test automatique selon la revendication 10, dans lequel la deuxième plaquette comprend du verre sur lequel est disposé un adhésif (103), et l'adhésif présente une composition qui fait que l'adhésif perd en adhésivité en réponse à la lumière ultraviolette.

15. Equipement de test automatique selon la revendication 10, dans lequel la première plaquette de semi-conducteur ou la deuxième plaquette présente une autre forme que ronde.
